Europäisches Patentamt

(19) **European Patent Office**

Office européen des brevets

(11) Veröffentlichungsnummer: **0 048 899**
**B1**

(12) # EUROPÄISCHE PATENTSCHRIFT

(45) Veröffentlichungstag der Patentschrift:
27.08.86

(51) Int. Cl.⁴: **G 03 F 7/10**

(21) Anmeldenummer: **81107370.9**

(22) Anmeldetag: **17.09.81**

(54) Verfahren zur Herstellung von Resiststrukturen.

(30) Priorität: **29.09.80 DE 3036615**

(43) Veröffentlichungstag der Anmeldung:
**07.04.82 Patentblatt 82/14**

(45) Bekanntmachung des Hinweises auf die Patenterteilung:
**27.08.86 Patentblatt 86/35**

(84) Benannte Vertragsstaaten:
**AT BE CH DE FR GB IT LI NL SE**

(73) Patentinhaber: **Siemens Aktiengesellschaft Berlin und München, Wittelsbacherplatz 2, D-8000 München 2 (DE)**

(72) Erfinder: **Birkle, Siegfried, Dr., Veit-Stoss-Strasse 46, D-8552 Höchstadt (DE)**
Erfinder: **Rubner, Roland, Dr., Buchenring 15, D-8551 Röttenbach (DE)**
Erfinder: **Hauschildt, Hans, Hutgraben 17, D-8520 Erlangen (DE)**
Erfinder: **Rissel, Eva-Maria, Lindenweg 19, D-8550 Forchheim (DE)**

(56) Entgegenhaltungen:
EP - A - 0 007 976
FR - A - 2 299 665

IBM TECHNICAL DISCLOSURE BULLETIN, Band 16, Nr. 9, Februar 1974, Seite 3028, New York (USA); E. GIPSTEIN et al.: "Sensitive positive electron-beam resists"
IBM TECHNICAL DISCLOSURE BULLETIN, Band 16, Nr. 11, April 1974, Seite 3745, New York (USA); O.U.NEED: "Polymethyl alpha cyanoacrylate homopolymers and copolymers as high-speed positive electron-beam resists"
JAPANESE JOURNAL OF APPLIED PHYSICS, Band 17, Nr. 3, März 1978, Seiten 541-550, Tokyo (JP); YOSHIAKI MIMURA et al.: "Deep-UV photolithography"
IBM J. RES. DEVELOP., Mai 1976, Seiten 213-221, New

(56) Entgegenhaltungen: (Fortsetzung)
York (USA);B.J.LIN: "Deep-UV Conformable-contact photolithography for bubble circuits"
JOURNAL OF APPLIED POLYMER SCIENCE, Band 21, 1977, Seiten 797-807, New York (USA); J.N. HELBERT et al.: "Radiation degradation of alpha-substituted acrylate polymers and copolymers"
POLYMER ENGINEERING AND SCIENCE, Band 17, Nr. 6, Juni 1977, Seiten 402-405; J.H. LAI et al.: "Studies of methyl methacrylate-methyl alpha-chloroacrylate copolymers and poly(methyl alpha-chloroacrylate) as electron sensitive positive resists"
ELECTRONICS REVIEW, Band 52, Nr. 19, 13. September 1979, Seiten 44-46; "Deep UV option promotes fine lines"

**Beschreibung**

Die Erfindung betrifft ein Verfahren zur Herstellung von Resiststrukturen auf der Basis von Positivresists mittels kurzwelliger UV-Strahlen.

Die Herstellung von Positivresiststrukturen mittels kurzwelliger UV-Strahlung (Deep-UV-Strahlen) ist bekannt; bevorzugt wird dabei im Bereich etwa zwischen 180 und 260 nm gearbeitet. Die erzeugten Resiststrukturen bzw. -masken, die vorzugsweise eine Dicke von etwa 1 μm aufweisen, werden insbesondere bei der Herstellung von integrierten Schaltkreisen eingesetzt.

Zur Herstellung von Resiststrukturen der genannten Art wurden bereits eine Reihe von Resistmaterialien eingesetzt. Eines dieser Materialien ist Polymethylmethacrylat (PMMA). Dieses Resistmaterial zeichnet sich durch einen guten Kontrast aus und ist für solche thermische Prozesse in der Halbleitertechnologie, bei denen Temperaturen über 135 °C nicht überschritten werden, ausreichend wärmeformbeständig. Bei der Verwendung handelsüblicher kurzwelliger UV-Lampen, wie Quecksilber-Niederdrucklampen, Xenon-Quecksilber-Hochdrucklampen und Deuteriumlampen, ist PMMA jedoch zu unempfindlich, d. h. zur Ausbildung von Resistbildern sind zu lange Belichtungszeiten notwendig. Bei der Herstellung von integrierten Schaltungen durch Bestrahlung ist es aber ausserordentlich wichtig, dass die Energiedosis und die Belichtungszeit, die zu einem ausreichenden Abbau des Polymermaterials erforderlich sind, so niedrig wie möglich gehalten werden, um den Prozess sowohl praktisch als auch ökonomisch in vertretbaren Grenzen durchführen zu können.

Polybutensulfon (PBS) ist zwar – bei 184 nm – gegenüber UV-Strahlen etwa 100 mal empfindlicher als Polymethylmethacrylat, wegen der geringen Wärmeformbeständigkeit und der thermischen Instabilität (Depolymerisation bei Temperaturen über 70 °C) ist es in der Praxis für thermische Prozesse der Halbleitertechnologie, wie «lift-off»-Verfahren, Trockenätzprozesse und Ionenimplantation, aber ungeeignet. Ein weiterer gravierender Nachteil des Positivresists PBS ist das zu hohe Absorptionsvermögen für kurzwellige UV-Strahlen, das zu einer sehr begrenzten Auflösung führt, so dass die für Strukturierungsprozesse oft erforderlichen 1 μm starken Resistmasken zur Übertragung kleinster Strukturen auf Halbleitersubstrate nicht mehr realisierbar sind.

Andere Resistmaterialien, wie Poly-2.2.3.4.4.4-hexafluor-butylmethacrylat und Polymethylisopropenylketon, sind zwar etwa 5 bis 6 mal empfindlicher als PMMA und somit zur Strukturierung von 1 μm starken Resistfilmen geeignet, die Wärmeformbeständigkeit dieser Materialien (Glas- bzw. Glasübergangstemperatur $T_g \sim 50 °C$ bzw. 62 °C) ist jedoch ebenfalls so gering, dass sie für thermische Prozesse, wie sie in der Halbleitertechnologie auftreten, ungeeignet sind.

Es ist bereits versucht worden, einen handelsüblichen Photolack auf der Basis von Novolaken und Diazochinonen wegen der ausgezeichneten Ätzresistenz und thermischen Stabilität als Deep-UV-Resist einzusetzen. Besonders nachteilig macht sich hierbei eine extrem hohe UV-Absorption im interessanten Anwendungsbereich unterhalb 260 nm bemerkbar, so dass nur Lackfilme unter 0,5 μm Dicke mit relativ steilen Flanken strukturiert werden können. Derart dünne Filme weisen aber nur eine sehr begrenzte Ätzresistenz auf. Ebenso nachteilig wirkt sich die hohe spektrale Empfindlichkeit des Lackes oberhalb 300 nm aus, d. h. ein hohes Auflösungsvermögen kann nur durch den Einsatz teurer und die Intensität stark reduzierender Interferenzfilter bzw. entsprechend vergüteter Reflexionsspiegel erreicht werden.

Es ist auch bereits versucht worden, PMMA – unter Beibehaltung der anderen guten Resisteigenschaften – zu sensibilisieren und damit die Empfindlichkeit zu steigern, und zwar etwa um das 5fache. Bei den Sensibilisatoren handelt es sich um flüssige Benzoesäurederivate, die im typischen Emissionsbereich, beispielsweise einer Xenon-Quecksilber-Kurzbogenlampe, absorbieren und die Energie auf das PMMA übertraten und somit vermehrte Kettenbrüche bewirken. Bei Verwendung eines derartig sensibilisierten Polymethylmethacrylats können sich jedoch nachteilige Auswirkungen auf die Resisteigenschaften ergeben, die eine Einschränkung der Anwendungsmöglichkeiten zur Folge haben. Insbesondere bei der Belackung bereits mehrfach strukturierter Substrate mit Höhenprofil mittels der Aufschleudertechnik werden nämlich die Strukturkanten weniger stark mit Lack beaufschlagt als die restliche Substratoberfläche. Es besteht deshalb die Gefahr, dass beim Schleudervorgang und beim sogenannten "prebake" der flüssige Sensibilisator an den weniger belackten Stufen schneller abdampft und damit auf dem Substrat unterschiedliche Empfindlichkeitsbereiche gebildet werden, welche die Auflösung in erheblichem Masse beeinträchtigen können. Ebenso nachteilig können sich die flüssigen bzw. leicht verdampfbaren Zusätze während des sogenannten «postbake» auf die Strukturqualität auswirken. Ausserdem besteht insbesondere bei dickeren Lackschichten beim Verdampfen des Sensibilisators die Gefahr der Bildung sogenannter "pinholes".

Bei der rationellen Herstellung von vorzugsweise etwa 1 μm starken Positivresiststrukturen mittels kurzwelliger UV-Strahlen sollen folgende Forderungen erfüllt werden:

– Zur Strukturierung soll eine geringe UV-Dosis benötigt werden;

– die Struktur soll steile Resistflanken besitzen;

– die Resiststruktur soll gegenüber halbleitertechnologischen Nassätzprozessen chemisch sowie bei Trockenätz- und "lift-off"-Verfahren thermisch beständig sein;

– durch Ausnutzung des UV-Spektralbereichs unter 260 nm und durch das besondere spektrale Absorptionsvermögen des Resistmaterials soll eine hohe Auflösung gewährleistet werden;

– durch eine Resisttransparenz oberhalb 260 nm sollen die ansonsten erforderlichen teuren und die Intensität vermindernden Interferenzfilter bzw. entsprechend vergütete Reflexionsspiegel zur Eliminierung des längerwelligen UV-Lampenemissionsbereichs entbehrlich gemacht werden.

Wie vorstehend bereits aufgezeigt wurde, werden diese Forderungen in ihrer Gesamtheit bislang nur unbefriedigend erfüllt. Mit den bisher verwendeten Resistmaterialien kann nämlich jeweils nur ein Teil der genannten Anforderungen erreicht werden.

Aufgabe der Erfindung ist es, ein Verfahren zur Herstellung von Positivresiststrukturen mittels kurzwelliger UV-Strahlen anzugeben, bei dem die vorstehend genannten Forderungen erfüllt sind. Insbesondere soll das Resistmaterial im Wellenlängenbereich etwa zwischen 180 und 260 nm eine erhöhte Empfindlichkeit und Auflösung besitzen, auch in Schichtdicken über 0,5 µm, sowie eine hohe Thermostabilität aufweisen, und ferner soll das Resistmaterial im Wellenlängenbereich oberhalb 260 nm vollständig transparent sein.

Dies wird erfindungsgemäss dadurch erreicht, dass als Resistmaterial Copolymere aus

a) 1 bis 70 Mol-% Alkylmethacrylat mit einem Alkylrest mit 1 bis 4 C Atomen und

b) 99 bis 30 Mol-% eines äthylenisch ungesättigten Monomeren mit Chlor- und/oder Cyansubstituenten verwendet werden.

Das beim erfindungsgemässen Verfahren eingesetzte Resistmaterial erfüllt die gestellten Forderungen in hohem Masse. Aufgrund seiner erhöhten thermischen Stabilität kann es bei halbleitertechnologischen Prozessen, wie Trockenätzprozesse und Metallisierungen nach dem Additivverfahren, bei denen es Temperaturen über 135 °C ausgesetzt ist, eingesetzt werden. Im Vergleich zu PMMA beispielsweise zeigt das beim erfindungsgemässen Verfahren verwendete Resistmaterial eine verbesserte Wärmeformbeständigkeit und eine höhere Glastemperatur ($T_g$ > 125 °C); die Kontrasteigenschaften sind gleich gut, die Empfindlichkeit ist aber 7 mal höher als diejenige von PMMA. Besonders vorteilhaft wirkt sich bei diesem Resistmaterial das spektrale Absorptionsvermögen aus, das – im Vergleich zu PMMA – unterhalb 220 nm vorhanden ist. Damit wird der kurzwellige Bereich kommerzieller Deep-UV-Lampen besser genutzt. Andererseits ist das Resistmaterial oberhalb 260 nm wie PMMA transparent, so dass das Auflösungsvermögen durch die längerwelligen UV-Anteile kommerzieller Lampen nicht beeinträchtigt wird und somit auf leistungsmindernde und kostspielige Interferenzfilter bzw. entsprechend vergütete Reflexionsspiegel verzichtet werden kann.

Das erfindungsgemässe Verfahren verläuft etwa folgendermassen:

a) Zunächst wird ein Film aus einem (unvernetzten) Polymermaterial mit der vorstehend angegebenen Zusammensetzung – in einem vorbestimmten Muster – mit kurzwelligen UV-Strahlen im Bereich etwa zwischen 180 und 260 nm beaufschlagt;

b) die Beaufschlagung mit kurzwelligem UV-Licht wird solange durchgeführt, bis das Polymermaterial (in den beaufschlagten Bereichen) zu niedermolekularen Produkten bzw. zu Polymeren mit besseren Lösungseigenschaften abgebaut ist;

c) dann werden die Abbauprodukte in den bestrahlten Bereichen entfernt.

Die Bestrahlung mit kurzwelligem UV-Licht findet dabei unter Sauerstoffausschluss statt, vorzugsweise unter Inertgas oder im Vakuum.

Vorzugsweise enthält das beim erfindungsgemässen Verfahren als Resistmaterial verwendete Copolymerisat 30 bis 50 Mol-% des äthylenisch ungesättigten Monomeren mit Chlor- und/oder Cyansubstituenten. Die Alkylmethacrylat-Einheiten des Copolymerisats sind insbesondere Methylmethacrylat und tert. Butylmethacrylat. Die Einheiten des äthylenisch ungesättigten Monomeren, das kein Methacrylat ist, sind insbesondere Methyl-α-cyanacrylat, Methyl-α-chloracrylat, α-Chloracrylnitril und α-Chloracrylsäure. Bevorzugt werden beim erfindungsgemässen Verfahren Copolymere aus Methylmethacrylat und Methyl-α-chloracrylat oder Methyl-α-cyanacrylat verwendet.

Aus der DE-OS 26 02 825 ist es zwar bekannt, dass zur Herstellung eines positiven Resistbildes mittels Elektronenstrahlen u.a. ein nichtvernetztes Polymermaterial mit einem Gehalt an 50 bis 99 Mol-% polymerisierten Alkylmethacrylat-Einheiten mit 1 bis 4 C-Atomen in der Alkylgruppe und 50 bis 1 Mol-% polymerisierten Einheiten wenigstens eines anderen äthylenisch ungesättigten Monomeren mit einem Gehalt an Halogen- und/oder Cyansubstituenten verwendet werden kann, es konnte aber nicht vorhergesehen werden, dass sich Polymermaterialien dieser Art vorteilhaft auch für die Beaufschlagung mit kurzwelligen UV-Strahlen im Bereich von 180 bis 260 nm eignen. So wurde überraschenderweise gefunden, dass beispielsweise ein Copolymerisat mit ca. 38 Mol-% Methyl-α-chloracrylat und 62 Mol-% Methylmethacrylat etwa 7 mal empfindlicher ist als das bisher empfindlichste Polymethylmethacrylat.

Aus der Tatsache, dass das genannte Copolymere auch gegenüber der Beaufschlagung mit Elektronen – unter vergleichbaren Entwicklungskriterien – etwa 3 bis 4 mal empfindlicher ist als PMMA, lässt sich, wie nachfolgend noch gezeigt wird, aber nicht allgemein der Schluss ziehen, dass alle guten Elektronenresists gleichzeitig auch gute Resists für die Beaufschlagung mit kurzwelligen UV-Strahlen sind. So ist es beispielsweise bekannt, dass ein Copolymeres aus Methylmethacrylat und Methacrylsäure als Elektronenresist etwa 100 mal empfindlicher ist als Polymethylmethacrylat, hinsichtlich der Empfindlichkeit gegenüber kurzwelligen UV-Strahlen ist zwischen den beiden Polymermaterialien jedoch kein Unterschied festzustellen. Das im Vergleich zu Polymethylmethacrylat bei der Beaufschlagung mit Elektronen ebenfalls etwa 100 mal empfindlichere Hexafluorbutylmethacrylat weist gegenüber kurzwelligen UV-Strahlen eine um den Faktor 20 reduzierte Empfindlichkeit auf, d.h. es ist etwa 5 mal empfindlicher als PMMA.

Noch krasser ist das Verhalten eines hochempfindlichen, zur Maskenherstellung fertigungsmässig eingesetzten Elektronen-Negativresists auf der Basis von Polyglycidylmethacrylat bei der Beaufschlagung mit kurzwelligen UV-Strahlen. Dieser Negativresist weist dabei nicht nur eine um den Faktor 100 verminderte UV-Empfindlichkeit im Bereich von 180 bis 260 nm auf, sondern er wird sogar zum Positivresist. Die eindeutig von der Strahlenart erheblich beeinflussten Resisteigenschaften zeigen deutlich, dass die Verwendungsmöglichkeit von Resistmaterialien für die verschiedenen Lithografie-Verfahren nicht vorhergesehen werden kann und in jedem Einzelfall überprüft werden muss.

Die beim erfindungsgemässen Verfahren eingesetzten Copolymeren können durch Lösungspolymerisation unter Verwendung eines freien Radikalinitiators hergestellt werden. Die Polymerisation wird vorzugsweise bei Temperaturen etwa zwischen 50 und 100 °C durchgeführt, wobei – je nach den übrigen Polymerisationsbedingungen – Polymere mit einem Zahlendurchschnittsmolekulargewicht im Bereich von etwa $20 \cdot 10^3$ bis $1000 \cdot 10^3$ und mit einem Gewichtsdurchschnittsmolekulargewicht im Bereich von etwa $40 \cdot 10^3$ bis $2000 \cdot 10^3$ resultieren.

Beim erfindungsgemässen Verfahren werden die Polymermaterialien – in Form von geeigneten Lösungen – nach dem sogenannten «spincoating»-Verfahren bis zur gewünschten Schichtdicke von etwa 50 nm bis 10 μm, vorzugsweise von ca. 0.5 bis 2 μm, auf eine Unterlage aufgeschleudert und zur Verdampfung des Lösungsmittels und zur Beseitigung der mechanischen Spannungen im Polymerfilm eine gewisse Zeit, vorzugsweise nicht weniger als 15 Minuten und nicht länger als 2 Stunden, über die Glastemperatur des Polymeren, jedoch unter dessen Zersetzungstemperatur, erhitzt, vorzugsweise im Bereich etwa zwischen 120 und 170 °C.

Die erhöhte Empfindlichkeit der Polymermaterialien machen diese, insbesondere auch in Verbindung mit Entwicklern wie Methyläthylketon, für Verfahren zur Strukturerzeugung unter Anwendung von kurzwelligen UV-Strahlen mit kommerziell erhältlichen Lampen in besonderem Masse geeignet. Dabei resultieren kurze Belichtungszeiten und das Verfahren wird ökonomisch durchführbar gestaltet. Durch das ausschliessliche Absorptionsvermögen des Polymermaterials für UV-Strahlen unter 260 nm kann insbesondere der kurzwellige UV-Anteil der kommerziellen Beleuchtungsquellen ausgenutzt werden, ohne dass der langwellige Emissionsbereich durch kostspielige und die nutzbare UV-Strahlenintensität stark mindernde Filter eliminiert werden muss. Die beim erfindungsgemässen Verfahren eingesetzten Copolymeren erweisen sich hierbei als ganz besonders vorteilhaft, da sie im Unterschied zu PMMA auch unterhalb 220 nm UV-Energie absorbieren und so zu einer Empfindlichkeitssteigerung beitragen.

Anhand eines Ausführungsbeispiels und einer Figur soll die Erfindung noch näher erläutert werden.

0,208 Mol Methyl-α-chloracrylat und 0,792 Mol Methylmethacrylat werden in Benzol gelöst. Zu dieser Lösung werden 0,5 mMol Azoisobutyronitril gegeben und dann wird unter Luftausschluss etwa 8 Stunden lang auf ca. 65 °C erhitzt. Das dabei erhaltene Polymere wird aus der Lösung mit Hexan ausgefällt und anschliessend aus Chloroform/Hexan umgefällt. Nach der Trocknung im Vakuum (bei einem Druck < 13 Pa) bei Raumtemperatur werden 26 g Polymeres erhalten, dessen Viskositätszahl bei etwa 50 ml/g, gemessen in Butanon bei 20 °C, liegt. Die Zusammensetzung wurde aufgrund des Chlorgehaltes ermittelt und ergab einen Anteil von 38 Mol-% Methyl-α-chloracrylat und 62 Mol-% Methylmethacrylat.

Mit einer etwa 7,5%igen Lösung des Polymeren in Chlorbenzol wird auf einem Siliciumwafer mit Siliciumdioxid-Oberfläche durch Aufschleudern bei etwa 4000 Upm ein etwa 0,6 μm dicker transparenter Film hergestellt. Nach etwa 45minütigem Trocknen des Filmes bei ca. 170 °C wird das teilweise durch eine Schlitzmaske abgedeckte Resistmaterial mit einer Quecksilberniederdrucklampe unterschiedlich lange bestrahlt. Der Film wird dann bei 20 °C in einem Entwicklergemisch aus Methyläthylketon und Äthanol 2 Minuten lang entwickelt, gespült und bei ca. 120 °C 30 Minuten lang nachgetrocknet. Die beaufschlagten Bereiche werden durch den Entwickler – entsprechend der Dosis – verschieden stark herausgelöst, so dass direkt eine Kontrastkurve erhalten wird. Die tatsächliche Dicke, die im nicht bestrahlten Bereich zurückbleibt, beträgt etwa 97 bis 100% der ursprünglichen Filmstärke.

Um die beim erfindungsgemässen Verfahren erzielbare reale Empfindlichkeitssteigerung im Vergleich zu Polymethylmethacrylat experimentell nachzuweisen, wurde ein PMMA-Film unter vergleichbaren Bedingungen hergestellt, bestrahlt und mit einem ebenfalls vernachlässigbaren Dunkelabtrag entwickelt.

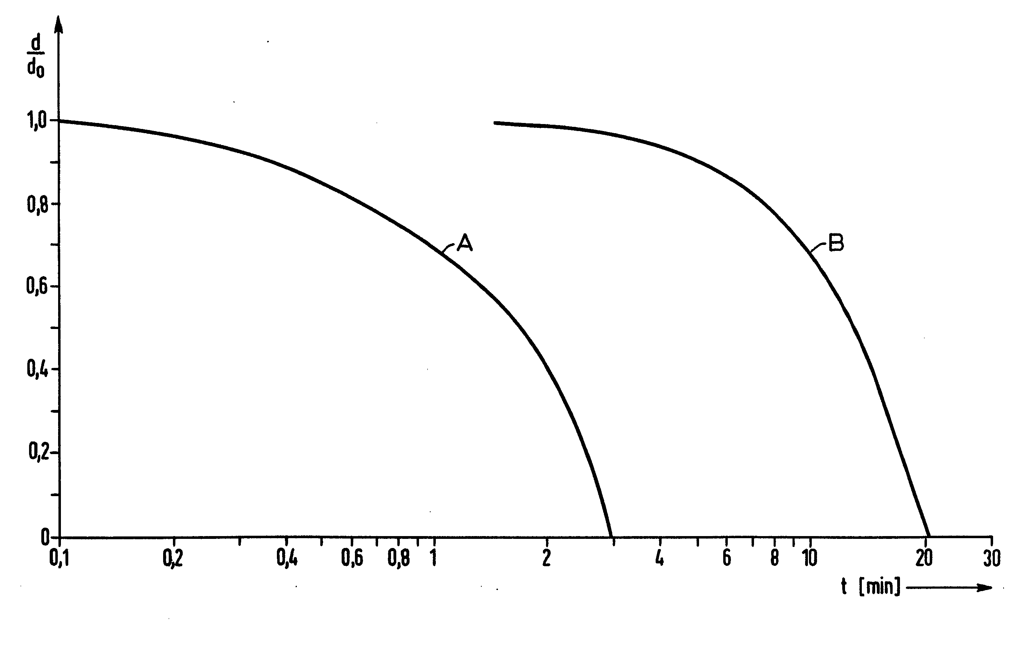

Das Ergebnis der Vergleichsexperimente ist aus der Figur ersichtlich, in der die Empfindlichkeitskurven dargestellt sind; dabei ist auf der Abszisse die Bestrahlungsdauer t in Minuten aufgetragen und auf der Ordinate die normierte Schichtdicke $d/d_o$. Aus der Figur ergibt sich, dass sich mit dem erfindungsgemässen Verfahren (Kurve A) – im Vergleich zu PMMA (Kurve B) – die Empfindlichkeit um den Faktor 7 steigern lässt.

## Patentansprüche

1. Verfahren zur Herstellung von Reststrukturen auf der Basis von Positivresists mittels kurzwelliger UV-Strahlen, dadurch gekennzeichnet, dass als Resistmaterial Copolymere aus
a) 1 bis 70 Mol-% Alkylmethacrylat mit einem Alkylrest mit 1 bis 4 C-Atomen und
b) 99 bis 30 Mol-% eines äthylenisch ungesättigten Monomeren mit Chlor- und/oder Cyansubstituenten verwendet werden.

2. Verfahren nach Anspruch 1, dadurch gekennzeichnet, dass als Resistmaterial Copolymere aus Methylmethacrylat und Methyl-α-chloracrylat oder Methyl-α-cyanacrylat verwendet werden.

## Claims

1. A method of producing resist patterns having a positive resist basis by means of short-wave UV-radiation, characterised in that copolymers consisting of
a) 1 to 70 mol% of an alkyl methacrylate with an alkyl residue having 1 to 4 C-atoms, and
b) 99 to 30 mol % of an ethylenically-unsaturated monomer substituted with chlorine and/or cyanogen are used as resist material.
2. A method as claimed in Claim 1, characterised in that copolymers consisting of methyl methacrylate and methyl α-chloroacrylate or methyl α-cyanoacrylate are used as resist material.

## Revendications

1. Procédé de préparation de structures de résiste à base de résistes positifs, au moyen de rayonnements ultraviolets à courtes longueurs d'onde, caractérisé en ce qu'il consiste à utiliser, comme matière de résiste, des copolymères constitués de
a) 1 à 70% en mole de méthacrylate d'alcoyle, dont la portion alcoyle a de 1 à 4 atomes de carbone, et
b) 99 à 30% en mole d'un monomère à insaturation éthylénique et ayant des substituants chloro et/ou cyano.
2. Procédé suivant la revendication 1, caractérisé en ce qu'il consiste à utiliser, comme matière de résiste, des copolymères de méthacrylate de méthyle et d'α-chloroacrylate de méthyle ou d'α-cyanoacrylate de méthyle.